# EUROPEAN PATENT APPLICATION

(11) **EP 2 259 357 A1**
(43) Date of publication of application: **08.12.2010**
(21) Application number: 09724867.8
(22) Date of filing: 24.03.2009
(51) Int. Cl.: H01L 51/42

(54) **ORGANIC PHOTOELECTRIC CONVERSION ELEMENT**

(30) Priority: 25.03.2008 JP 2008077979; 22.05.2008 JP 2008133905; 03.02.2009 JP 2009022371
(71) Applicant: Sumitomo Chemical Company, Limited, Tokyo 104-8260 (JP)
(72) Inventor: UETANI, Yasunori, Tsukuba-shi Ibaraki 305-0045 (JP)
(74) Representative: Vossius & Partner
(86) International application number: PCT/JP2009/056425
(87) International publication number: WO 2009/119871

(57) **Abstract**

Disclosed is an organic photoelectric conversion element including an anode, a cathode, an active layer, and a functional layer, wherein the anode contains a metal, the anode and the functional layer are adjacent to each other, and the functional layer is formed using a solution having a pH value of 5 to 9. Examples of the metal include aluminum, magnesium, titanium, chromium, iron, nickel, copper, zinc, gallium, zirconium, molybdenum, silver, indium, and tin. Preferably, the active layer contains a conjugated polymer compound and a fullerene derivative.

## Description

### TECHNICAL FIELD

The invention relates to an organic photoelectric conversion element.

### BACKGROUND ART

In recent years, attentions have been focused on organic photoelectric conversion elements (organic solar batteries, optical sensors, and the like) which utilize optical energy, and in order to improve the characteristics thereof, various studies are carried out on organic photoelectric conversion elements that include functional layers having various functions between an active layer and electrodes thereof. As one example of the organic photoelectric conversion element containing the functional layer, a solar battery has been known in which an anode and the functional layer are adjacent to each other, and the functional layer is prepared as a layer formed by using a strongly acidic solution that contains poly(3,4-ethylenedioxythiophene) (PEDOT) and poly(4-styrene sulfonate)(PSS).

("Technical Digest of the International PVSEC-17", 17th International Photovoltaic Science and Engineering Conference (PVSEC-17) Organizing Committee, issued on December 3, 2007, 6P-P5-17, pp1046-1047)

### DISCLOSURE OF THE INVENTION

However, the above-mentioned photoelectric conversion element does not necessarily provide a sufficient photoelectric conversion efficiency.

An object of the present invention is to provide an organic photoelectric conversion element that has a high photoelectric conversion efficiency.

The present invention provides an organic photoelectric conversion element including an anode, a cathode, an active layer and a functional layer, wherein the anode contains a metal, the anode and the functional layer are adjacent to each other, and the functional layer is formed by using a solution having a pH value of 5 to 9.

### MODE FOR CARRYING OUT THE INVENTION

The present invention will be described in detail below.

### <Organic Photoelectric Conversion Element>

The organic photoelectric conversion element of the present invention includes an anode, a cathode, an active layer and a functional layer, wherein the anode contains a metal, the anode and the cathode are adjacent to each other, and the functional layer is formed by using a solution having a pH value of 5 to 9. The functional layer is preferably adjacent to the active layer on a surface on the side opposed to the surface on which it is adjacent to the anode.

The functional layer possessed by the organic photoelectric conversion element of the present invention is preferably made of a polymer compound, and more preferably made of a polymer compound having a high conductive property.

The conductive property of the highly conductive polymer compound is usually from 10⁻⁵ to 10⁵ S/cm in conductivity, and more preferably from 10⁻³ to 10⁴ S/cm in conductivity.

The functional layer made of the polymer compound having a high conductive property is adjacent to the anode and the active layer, and thus the adhesion between the anode and the active layer can be enhanced and the injection efficiency of holes (positive holes) from the active layer to the anode (positive electrode in a solar battery) can also be enhanced.

A solution used for forming the functional layer is a solution containing a material for constituting the functional layer and a solvent, and the solution has a pH value in a range from 5 to 9. From the viewpoint of enhancing the photoelectric conversion efficiency of the organic photoelectric conversion element, the pH value is preferably 6 to 8. The solvent may be exemplified by water and alcohol. Examples of alcohol include methanol, ethanol, isopropanol, butanol, ethylene glycol, propylene glycol, butoxyethanol and methoxyethanol. The solution may contain two or more kinds of these solvents. Examples of the material for constituting the functional layer include a polymer compound containing a thiophene-diyl group, a polymer compound having an aniline-diyl group, and a polymer compound having a pyrrole-diyl group. These polymer compounds may have an acid group, such as a sulfonic acid group, and examples thereof include poly(thiophene) and poly(aniline) having an acid group, such as a sulfonic acid group, as a substituent. These poly(thiophene) and poly(aniline) may further have a substituent, and examples thereof include a halogen atom, an alkyl group having 1 to 20 carbon atoms, an alkoxy group having 1 to 20 carbon atoms, an aryl group having 6 to 60 carbon atoms, and a group represented by the following formula (5) (in formula (5), g represents an integer of 1 to 6, and h represents an integer of 0 to 5), and from the viewpoint of solubility to water and an alcohol solvent, an alkoxy group or the group indicated by the formula (5) is preferably contained therein.

-O-(CH₂)_{g}-O-(CH₂)ₕ-CH₃ (5)

In the present invention, the solution may include dispersion systems, such as emulsions (emulsion liquids) and suspensions (suspension liquids).

In the present invention, the measurement of the pH of the solution is carried out by using pH test paper.

The functions possessed by the functional layer are exemplified by a function for enhancing the injection efficiency of positive holes into the anode, a function for preventing the injection of electrons from the active layer, a function for enhancing the transporting function for holes, a function for enhancing the flatness upon carrying out a vapor-deposition on the anode, a function for protecting the active layer from erosion by the solvent in a case where the anode is produced by using a coating method, a function for reflecting light that is made incident from the cathode and a function for suppressing degradation of the active layer.

Examples of the functional layer include a positive hole (hole) injection layer, a positive hole transporting layer, and an electron blocking layer.

The anode possessed by the organic photoelectric conversion element of the present invention includes a metal. The anode may contain a metal oxide, a metal halide, and the like, and when the weight of a metal is 100, the total of the weight of the metal oxide and the weight of the metal halide is preferably 10 or less, and the anode is more preferably made substantially from only metal.

Examples of the metal include lithium, beryllium, sodium, magnesium, aluminum, potassium, calcium, scandium, titanium, vanadium, chromium, manganese, iron, cobalt, nickel, copper, zinc, gallium, germanium, rubidium, strontium, yttrium, zirconium, niobium, molybdenum, ruthenium, rhodium, palladium, silver, cadmium, indium, tin, antimony, cesium, barium, lanthanum, hafnium, tantalum, tungsten, rhenium, osmium, iridium, platinum, gold, mercury, thallium, lead, bismuth and lanthanide. An alloy made of these metals, or graphite or an interlayer compound or the like of any of these metals and graphite may be used. Preferred among these metals are aluminum, magnesium, titanium, chromium, iron, nickel, copper, zinc, gallium, zirconium, molybdenum, silver, indium and tin. From the viewpoint of manufacturing costs, aluminum is more preferable. When the functional layer is formed by using a solution having a pH value of 5 to 9, it is possible to enhance the photoelectric conversion efficiency of the organic photoelectric conversion element. The reason that the efficiency is enhanced is presumably because oxidation, erosion and the like of the anode adjacent to the functional layer are suppressed.

Examples of the organic photoelectric conversion element of the present invention include:
1. An organic photoelectric conversion element that has an anode and a cathode, a first active layer arranged between the anode and the cathode and containing an electron accepting compound, a second active layer arranged adjacent to the first organic layer and containing an electron donating compound, and a functional layer arranged between the anode and the second active layer so as to be adjacent to the anode;
2. An organic photoelectric conversion element that has an anode and a cathode, an active layer arranged between the anode and the cathode and containing an electron accepting compound and an electron donating compound, and a functional layer arranged between the anode and the active layer so as to be adjacent to the anode; and
3. An organic photoelectric conversion element that has an anode and a cathode, an active layer arranged between the anode and the cathode and containing an electron accepting compound and an electron donating compound, and a functional layer arranged between the anode and the active layer so as to be adjacent to the anode, wherein the electron accepting compound is a fullerene derivative.

Moreover, in the organic photoelectric conversion element of the above-mentioned 3, the ratio of the fullerene derivative in the active layer containing the fullerene derivative and the electron donating compound is preferably 10 to 1000 parts by weight, and more preferably 50 to 500 parts by weight, relative to 100 parts by weight of the electron donating compound.

The above-mentioned 2 or 3 is preferable as the organic photoelectric conversion element, and the above-mentioned 3 is more preferable from the viewpoint that many hetero-junction interfaces are included. Moreover, an additional layer may be formed. The additional layer is exemplified by a charge transporting layer for transporting holes or electrons, and a buffer layer. The buffer layer is, for example, arranged between the cathode and the active layer.

Then, an operation mechanism of the organic photoelectric conversion element will be described. Optical energy, made incident from the transparent or semi-transparent electrode, is absorbed by the electron accepting compound and/or the electron donating compound, and excitons, each formed by an electron and a hole coupled to each other, are generated. When the generated exciton is moved to reach a hetero-junction interface at which the electron accepting compound and the electron donating compound are adjacent to each other, the electron and the hole are separated due to a difference in the HOMO energy and LUMO energy of the respective compounds on the interface so that a charge (an electron and a hole) that can move independently is generated. The charge thus generated is transferred to each of the corresponding electrodes, and can be taken out as an electric energy (current).

The electron accepting compound suitably used for the organic photoelectric conversion element is made so that the HOMO energy of the electron accepting compound is higher than the HOMO energy of the electron donating compound and the LUMO energy of the electron accepting compound is also higher than the LUMO energy of the electron donating compound.

The organic photoelectric conversion element of the present invention is normally formed on a substrate. This substrate has an electrode formed thereon and any substrate may be used as long as no change occurs upon forming an organic layer thereon. Examples of the material for the substrate include glass, plastic, polymer film and silicon. In the case of an opaque substrate, the opposed electrode (that is, an electrode farther from the substrate) is preferably transparent or semi-transparent.

Examples of a material for the cathode include a conductive metal oxide film, and a semi-transparent metal thin film. Specific examples of the material for the cathode include a film (NESA or the like) made of a conductive material such as indium oxide, zinc oxide, tin oxide, as well as indium-tin-oxide (ITO) and indium-zinc-oxide that are composites of them, and gold, platinum, silver and copper, and preferred among them are ITO, indium-zinc-oxide and zinc oxide. As the material for the cathode, an organic transparent conductive film, made from polyaniline and derivatives thereof, or polythiophene and derivatives thereof, or the like, may be used.

Examples of the manufacturing method of the electrode include a vapor deposition method, a sputtering method, an ion plating method, and a plating method. In addition, a semi-transparent metal thin film is formed through a coating method by using a metal ink, a metal paste, a low-melting-point metal, or the like so that the metal electrode can be produced.

As the material used for the charge transporting layer serving as the additional layer, that is, the hole transporting layer and electron transporting layer, electron donating compounds and electron accepting compounds, each of which will be described later, can be used.

As the material used for a buffer layer as an additional layer, in a case where the buffer layer is arranged between the cathode and the active layer, for example, fine particles of an inorganic semiconductor, such as a halide of alkali metal or alkali earth metal, for example, lithium fluoride, an oxide thereof, and titanium oxide, can be used.

The electron donating compound may be a low molecular compound or a high molecular compound. Examples of the low molecular compound include phthalocyanine, metal phthalocyanine, porphyrin, metal porphyrin, oligothiophene, tetracene, pentacene, rubrene and the like. Examples of the high molecular compound include polyvinyl carbazole and a derivative thereof, polysilane and a derivative thereof, a polysiloxane derivative having aromatic amine in its side chain or main chain, polyaniline and a derivative thereof, polythiophene and a derivative thereof, polypyrrole and a derivative thereof, polyphenylene vinylene and a derivative thereof, polythienylenevinylene and a derivative thereof, and polyfluorene and a derivative thereof.

The electron accepting compound may be a low molecular compound or a high molecular compound. Examples of the low molecular compound include an oxadiazole derivative, anthraquinodimethane and a derivative thereof, benzoquinone and a derivative thereof, naphthoquinone and a derivative thereof, anthraquinone and a derivative thereof, tetracyanoanthraquinodimethane and a derivative thereof, a fluorenone derivative, diphenyldicyanoethylene and a derivative thereof, a diphenoquinone derivative, a metal complex of 8-hydroxyquinoline and a derivative thereof, polyquinoline and a derivative thereof, polyquinoxaline and a derivative thereof, polyfluorene and a derivative thereof, fullerene such as C₆₀ and a derivative thereof, and a phenanthrene derivative such as bathocuproin. Examples of the high molecular compound include polyvinylcarbazole and a derivative thereof, polysilane and a derivative thereof, a polysiloxane derivative having aromatic amine in its side chain or its main chain, polyaniline and a derivative thereof, polythiophene and a derivative thereof, polypyrrole and a derivative thereof, polyphenylenevinylene and a derivative thereof, polythienylenevinylene and a derivative thereof, and polyfluorene and a derivative thereof.

In particular, fullerene and a derivative thereof are preferable.

The fullerenes can be exemplified by fullerene such as C₆₀, C₇₀, and carbon nanotubes and derivatives thereof. Examples of the fullerene derivatives include the following compounds:

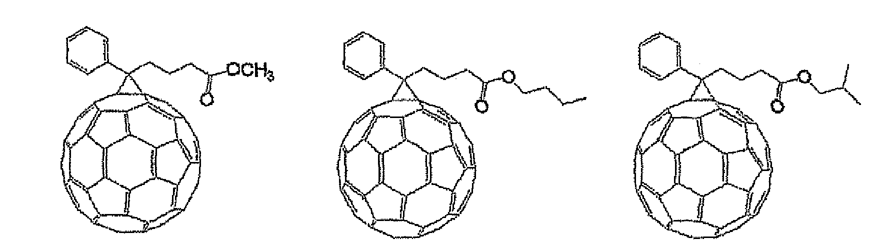

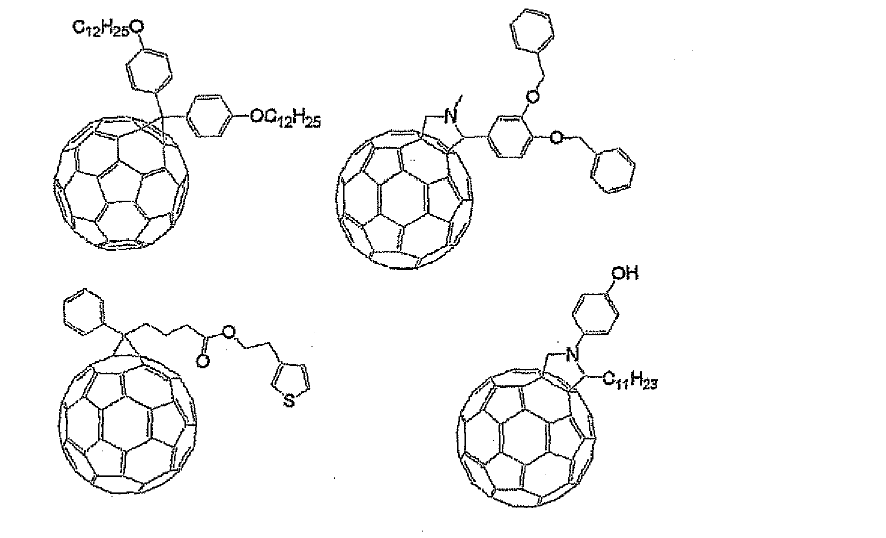

The active layer possessed by the organic photoelectric conversion element of the present invention preferably contains a polymer compound, and may contain one kind of polymer compound or two or more kinds of polymer compounds in combination. In order to enhance the charge transporting characteristic of the active layer, the active layer may further contain an electron donating compound and/or an electron accepting compound. In particular, the active layer preferably contains a conjugated polymer compound and a fullerene derivative. For example, an organic thin-film containing a conjugated polymer compound and a fullerene derivative can be used as the active layer. Examples of the conjugated polymer compound include a polymer compound having a fluorene-diyl group and a polymer compound having a thiophene-diyl group.

The organic thin film has a film thickness that is usually 1 nm to 100 µm, preferably 2 nm to 1000 nm, more preferably 5 nm to 500 nm, and most preferably 20 nm to 200 nm.

### <Method of Manufacturing Functional Layer>

The manufacturing method of the functional layer, for example, may be given by a method for forming a film from the solution.

The coating methods which can be used for forming a film are exemplified by a spin coating method, a casting method, a micro-gravure coating method, a gravure coating method, a bar coating method, a roll coating method, a wire-bar coating method, a dip coating method, a spray coating method, a screen printing method, a flexographic printing method, an offset printing method, an inkjet printing method, a dispenser printing method, a nozzle coating method, and a capillary coating method, and preferred among these are the spin coating method, flexographic printing method, inkjet printing method and dispenser method.

The manufacturing method of the organic thin film used for the active layer is exemplified by a method for forming a film from a composition containing a solvent, a conjugated polymer compound and a fullerene derivative. As the film-forming method, the same method as that described in the manufacturing method of the functional layer can be used.

Examples of the solvent used for film-forming the active layer from a solution include hydrocarbon solvents, such as toluene, xylene, mesitylene, tetralin, decalin, bicyclohexyl, n-butylbenzene, s-butylbenzene and t-butylbenzene; halogenated saturated hydrocarbon solvents, such as carbon tetrachloride, chloroform, dichloromethane, dichloroethane, chlorobutane, bromobutane, chloropentane, bromopentane, chlorohexane, bromohexane, chlorocyclohexane and bromocyclohexane; halogenated unsaturated hydrocarbon solvents, such as chlorobenzene, dichlorobenzene and trichlorobenzene; and ether solvents, such as tetrahydrofuran and tetrahydropyran.

The organic photoelectric conversion element of the present invention is used through a process in which, upon irradiation with light such as solar light from the transparent or semi-transparent electrode, a photo-electromotive force is generated between the electrodes so as to be operated as an organic thin-film solar battery.

By integrating a plurality of organic thin-film solar batteries, the element can also be used as an organic thin-film solar battery module.

By irradiating the element with light from the transparent or semi-transparent electrode, with a voltage being applied between the electrodes, a photoelectric current is allowed to flow so that the resulting element can be operated as an organic photo-sensor. By integrating a plurality of the organic photo-sensors, the resulting element can also be used as an organic image sensor.

### EXAMPLES

The following description will describe examples so as to explain the present invention in more detail; however, the present invention is not limited thereto.

In the following examples, the polystyrene reduced number-average molecular weight and weight-average molecular weight of a polymer were determined by using a GPC (PL-GPC2000) manufactured by GPC Laboratory. The polymer was dissolved in o-dichlorobenzene so as to have a concentration of about 1% by weight. As a mobile phase for GPC, o-dichlorobenzene was used, and this was allowed to flow at a flow rate of 1 mL/min at a measuring temperature of 140°C. As the column, three PLGEL 10 µm-MIXED-B's (manufactured by PL Laboratory) were joined in series, and used.

### Synthesis Example 1

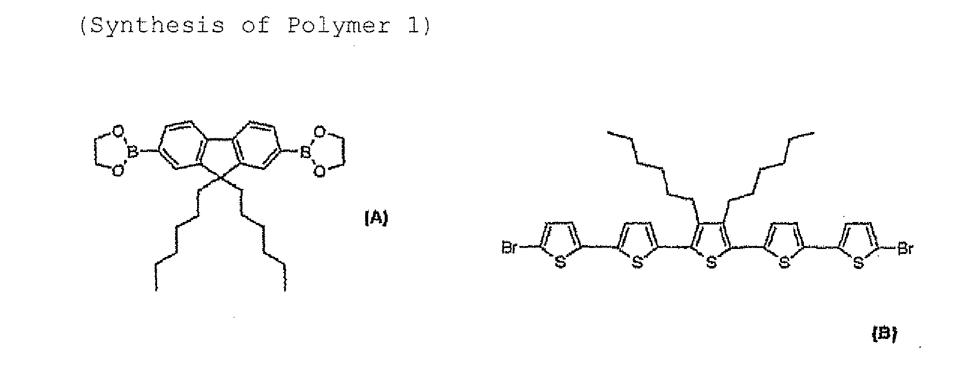

A compound A (7.928 g, 16.72 mmol), a compound B (13.00 g, 17.60 mmol), methyltrioctylammonium chloride (trade name: aliquat336, manufactured by Aldrich, CH₃N[CH₂]₇CH₃]₃Cl, density 0.884 g/mL, 25°C, trademark of Henkel Corporation) (4.979 g) and toluene (405 mL) were charged into a 2-L four-neck flask, in which an atmosphere was replaced with argon, and this system was subjected to bubbling with argon gas for 30 minutes to be degassed while being stirred. To this was added dichlorobis(triphenylphosphine)palladium (II)(0.02 g), and then heated to 105°C, and to this was further added dropwise an aqueous 2 mol/L sodium carbonate solution (42.2 mL) while being stirred. After completing the addition, this was allowed to react for 5 hours, and to this were added phenylboric acid (2.6 g) and toluene (1.8 mL), and stirred at 105°C for 16 hours. To this were further added toluene (700 mL) and an aqueous 7.5% sodium diethyldithiocarbamate trihydrate solution (200 mL), and stirred at 85°C for 3 hours. By removing the water layer from the reaction solution, the organic layer was obtained, and washed with 300 mL of ion exchange water at 60°C two times, then washed with 300 mL of 3% acetic acid at 60°C once, and further washed with 300 mL of ion exchange water at 60°C three times. The organic layer was allowed to pass through a column filled with celite, alumina and silica, and the column was washed with heated toluene (800 mL). The resulting solution was condensed up to 700 mL, and then poured into 2 L of methanol to be re-precipztated, thereby obtaining a polymer. The polymer was recovered by filtration, and was then washed with 500 mL of methanol, acetone and methanol. This was then vacuum-dried for one night at 50°C to obtain a pentathienyl-fluorene copolymer (hereinafter, referred to as "polymer 1") (12.21 g). The polymer 1 had a number-average molecular weight of 5.4 × 10⁴ and a weight-average molecular weight of 1.1 × 10⁵ in terms of polystyrene equivalent.

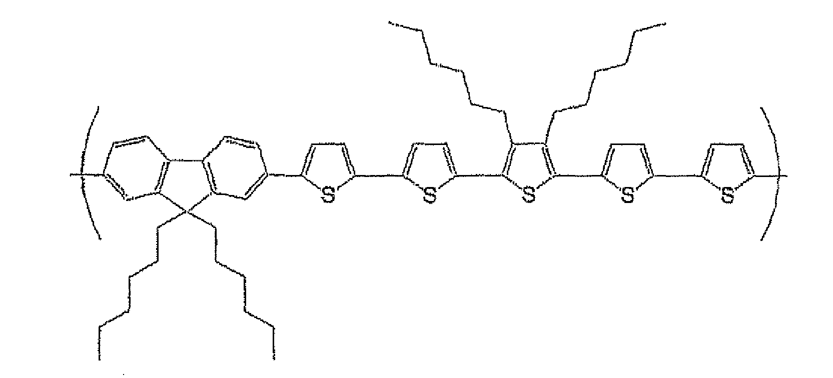

### (Preparation of Composition 1)

[6,6] -phenyl C61-methylethyl acetate (PCBM) (15 parts by weight) (E100: manufactured by Frontier Carbon Corporation) serving as a fullerene derivative and the polymer 1 (5 parts by weight) serving as an electron donating compound were mixed with o-dichlorobenzene (1000 parts by weight) serving as a solvent. Thereafter, the mixture was filtered by using a Teflon (registered trademark) filter with a pore diameter of 1.0 µm to prepare a composition 1.

### Example 1

### (Production and Evaluation of Organic Thin-Film Solar Battery)

A glass substrate on which an ITO film was deposited with a thickness of 150 nm as a cathode by a sputtering method was coated with the composition 1 by using a spin coating method to obtain an active layer (film-thickness: about 100 nm) for an organic thin-film solar battery. Thereafter, an HIL691 solution (trade name: Plexcore HIL691, manufactured by Plextronics Co., Ltd.) was applied by a spin coating method to obtain a hole transporting layer (film thickness: about 50 nm) serving as a functional layer. When the pH value of the HIL691 solution was measured by pH test paper (trade name "UNIV Universal" Serial Number "07011030", manufactured by Advantec MFS, Inc.), the pH value was 7. Thereafter, this was dried for 60 minutes in vacuum at room temperature. Then, Al was vapor-deposited thereon with a thickness of 100 nm as an anode, by using a vacuum vapor depositing machine. Upon the vapor deposition, the degree of vacuum was 1 to 9 × 10⁻³ Pa in all cases. One of the surfaces of the functional layer was adjacent to the anode, and the other surface was adjacent to the active layer. The shape of the resulting organic thin-film solar battery had a square shape of 2 mm × 2 mm. The photoelectric conversion efficiency of the resulting organic thin-film solar battery was measured by using a solar simulator (trade name: OTENTO-SUNII, manufactured by Bunkoukeiki Co.,Ltd.: AM1.5G filter, irradiance 100 mW/cm²) in which the battery was irradiated with constant light and an electric current and a voltage thus generated were measured. The photoelectric conversion efficiency was 1.3%.

### Example 2

### (Production and Evaluation of Organic Thin-Film Solar Battery)

A glass substrate on which an ITO film was deposited with a thickness of 150 nm as a cathode by a sputtering method was vapor-deposited with LiF by using a vacuum vapor depositing machine so as to have a thickness of 4 nm. Thereafter, the composition 1 was applied by using a spin coating method to obtain an active layer (film-thickness: about 100 nm) for an organic thin-film solar battery. Thereafter, an HIL691 solution (trade name: Plexcore HIL691, manufactured by Plextronics Co., Ltd.) was applied by a spin coating method to obtain a hole transporting layer (film thickness: about 50 nm) serving as a functional layer. This was then subjected to a drying process in vacuum at room temperature for 60 minutes. Thereafter, Al was vapor-deposited thereon with a thickness of 100 nm as an anode, by using a vacuum vapor depositing machine. Upon the vapor deposition, the degree of vacuum was 1 to 9 × 10⁻³ Pa in all cases. One of the surfaces of the functional layer was adjacent to the anode, and the other surface was adjacent to the active layer. The shape of the resulting organic thin-film solar battery had a square shape of 2 mm × 2 mm. The photoelectric conversion efficiency of the resulting organic thin-film solar battery was measured by using a solar simulator (trade name: OTENTO-SUNII, manufactured by Bunkoukeiki Co.,Ltd.: AM1.5G filter, irradiance 100 mW/cm²) in which the battery was irradiated with constant light and an electric current and a voltage thus generated were measured. The photoelectric conversion efficiency was 2.0%.

### Example 3

### (Production and Evaluation of Organic Thin-Film Solar Battery)

A glass substrate on which an ITO film was deposited with a thickness of 150 nm as a cathode by a sputtering method was coated with a solution prepared by diluting a titania sol (PASOL HPW-10R, manufactured by JGC C&C Ltd.) with four times as much water, by using a spin coating method, to obtain an electron transporting layer (film thickness: about 20 nm). Thereafter, the composition 1 was applied by using a spin coating method to obtain an active layer (film-thickness: about 100 nm). Thereafter, an HIL691 solution (trade name: Plexcore HIL691, manufactured by Plextronics Co., Ltd.) was applied by a spin coating method to obtain a hole transporting layer (film thickness: about 110 nm) serving as a functional layer.

This was then subjected to a drying process in vacuum at room temperature for 60 minutes. Finally, Al was vapor-deposited thereon with a thickness of 100 nm as an anode, by using a vacuum vapor depositing machine. Upon the vapor deposition, the degree of vacuum was 1 to 9 × 1.0⁻³ Pa in all cases. One of the surfaces of the functional layer was adj acent to the anode, and the other surface was adjacent to the active layer. The shape of the resulting organic thin-film solar battery had a square shape of 2 mm × 2 mm.

The photoelectric conversion efficiency of the resulting organic thin-film solar battery was measured by using a solar simulator (trade name: OTENTO-SUNII, manufactured by Bunkoukeiki Co.,Ltd.: AM1.5G filter, irradiance 100 mW/cm²) in which the battery was irradiated with constant light and a voltage thus generated was measured. The photoelectric conversion efficiency was 2.4%.

### Example 4

### (Production and Evaluation of Organic Thin-Film Solar Battery)

A glass substrate on which an ITO film was deposited with a thickness of 150 nm as a cathode by a sputtering method was coated with the composition 1 by using a spin coating method to obtain an active layer (film-thickness: about 100 nm) for an organic thin-film solar battery. Thereafter, an OC1200 solution (trade name: Plexcore OC1200, manufactured by Plextronics Co., Ltd., purchased from Sigma Aldrich Corporation) was applied by a spin coating method to obtain a hole transporting layer (film thickness: about 50 nm) serving as a functional layer. When the pH value of the OC1200 solution was measured by pH test paper (trade name "UNIV Universal" Serial Number "07011030", manufactured by Advantec MFS, Inc.), the pH value was 7. Thereafter, this was dried for 60 minutes in vacuum at room temperature. Then, Al was vapor-deposited thereon with a thickness of 100 nm as an anode, by using a vacuum vapor depositing machine. Upon the vapor deposition, the degree of vacuum was 1 to 9 × 10⁻³ Pa in all cases. One of the surfaces of the functional layer was adjacent to the anode, and the other surface was adjacent to the active layer. The shape of the resulting organic thin-film solar battery had a square shape of 2 mm × 2 mm. The photoelectric conversion efficiency of the resulting organic thin-film solar battery was measured by using a solar simulator (trade name: OTENTO-SUNII, manufactured by Bunkoukeiki Co.,Ltd.: AM1.5G filter, irradiance 100 mW/cm²) in which the battery was irradiated with constant light and an electric current and a voltage thus generated were measured. The photoelectric conversion efficiency was 1.1%.

Plexcore OC1200 is a 2% solution of sulfonated polythiophene represented by the following formula in ethyleneglycol monobutyl ether/water (3 : 2).

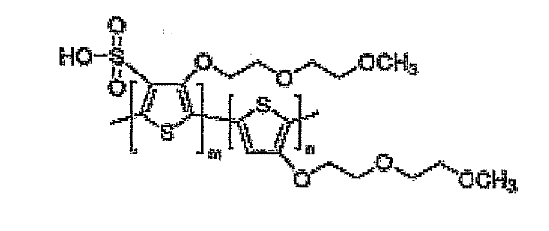

### Example 5

### (Production and Evaluation of Organic Thin-Film Solar Battery)

A glass substrate on which an ITO film was deposited with a thickness of 150 nm as a cathode by a sputtering method was coated with a solution prepared by diluting a titania sol (PASOL HPW-10R, manufactured by Catalysts & Chem. Ind. Co.) with four times as much water by using a spin coating method to obtain an electron transporting layer (film thickness: about 20 nm). Thereafter, the composition 1 was applied by using a spin coating method to obtain an active layer (film-thickness: about 100 nm). Thereafter, an OC1200 solution (trade name: Plexcore OC1200, manufactured by Plextronics Co., Ltd., purchased from Sigma Aldrich Corporation) was applied by a spin coating method to obtain a hole transporting layer (film thickness: about 50 nm) serving as a functional layer.

This was then subjected to a drying process in vacuum at room temperature for 60 minutes. Finally, Al was vapor-deposited thereon with a thickness of 100 nm as an anode, by using a vacuum vapor depositing machine. Upon the vapor deposition, the degree of vacuum was 1 to 9 × 10⁻³ Pa in all cases. One of the surfaces of the functional layer was adj acent to the anode, and the other surface was adjacent to the active layer. The shape of the resulting organic thin-film solar battery had a square shape of 2 mm × 2 mm.

The photoelectric conversion efficiency of the resulting organic thin-film solar battery was measured by using a solar simulator (trade name: OTENTO-SUNII, manufactured by Bunkoukeiki Co.,Ltd.: AM1.5G filter, irradiance 100 mW/cm²) in which the battery was irradiated with constant light and a voltage thus generated was measured. The photoelectric conversion efficiency was 2.7%.

### Comparative Example 1

### (Production and Evaluation of Organic Thin-Film Solar Battery)

A glass substrate on which an ITO film was deposited with a thickness of 150 nm as a cathode by a sputtering method was coated with the composition 1 by using a spin coating method to obtain an active layer (film thickness: about 100 nm) for an organic thin-film solar battery. Thereafter, a PEDOT : PSS solution (trade name: CLEVIOS AI4083, manufactured by H.C. Starck GmbH) was applied by a spin coating method to obtain a functional layer (film thickness: about 50 nm). When the pH value of the AI4083 solution was measured by pH test paper (trade name "UNIV Universal" Serial Number "07011030", manufactured by Advantec MFS, Inc.), the pH value was 2. Thereafter, this was dried for 60 minutes in vacuum at room temperature. Then, Al was vapor-deposited thereon with a thickness of 100 nm as an anode, by using a vacuum vapor depositing machine. Upon the vapor deposition, the degree of vacuum was 1 to 9 × 10⁻³ Pa in all cases. The shape of the resulting organic thin-film solar battery had a square shape of 2 mm × 2 mm. The photoelectric conversion efficiency of the resulting organic thin-film solar battery was measured by using a solar simulator (trade name: OTENTO-SUNII, manufactured by Bunkoukeiki Co.,Ltd.: AM1.5G filter, irradiance 100 mW/cm²) in which the battery was irradiated with constant light and an electric current and a voltage thus generated were measured. The photoelectric conversion efficiency was 0.0%.

### Comparative Example 2

### (Production and Evaluation of Organic Thin-Film Solar Battery)

A glass substrate on which an ITO film was deposited with a thickness of 150 nm as a cathode by a sputtering method was vapor-deposited with LiF by using a vacuum vapor depositing machine so as to have a thickness of 4 nm. Thereafter, the composition 1 was applied onto the substrate by using a spin coating method to obtain an active layer (film-thickness: about 100 nm) for an organic thin-film solar battery. Thereafter, a PEDOT : PSS solution (trade name: CLEVIOS AI4083, manufactured by H.C. Starck GmbH) was applied by a spin coating method to obtain a functional layer (film thickness: about 50 nm). Thereafter, this was dried for 60 minutes in vacuum at room temperature. Then, Al was vapor-deposited thereon with a thickness of 100 nm as an anode, by using a vacuum vapor depositing machine. Upon the vapor deposition, the degree of vacuum was 1 to 9 × 10⁻³ Pa in all cases. The shape of the resulting organic thin-film solar battery had a square shape of 2 mm × 2 mm. The photoelectric conversion efficiency of the resulting organic thin-film solar battery was measured by using a solar simulator (trade name: OTENTO-SUNII, manufactured by Bunkoukeiki Co.,Ltd.: AM1.5G filter, irradiance 100 mW/cm²) in which the battery was irradiated with constant light and an electric current and a voltage thus generated were measured. The photoelectric conversion efficiency was 0.0%.

### Comparative Example 3

### (Production and Evaluation of Organic Thin-Film Solar Battery)

A glass substrate on which an ITO film was deposited with a thickness of 150 nm as a cathode by a sputtering method was coated with a solution prepared by diluting a titania sol (PASOL HPW-10R, manufactured by JGC C&C Ltd.) with four times as much water by using a spin coating method to obtain an electron transporting layer (film thickness: about 20 nm). Thereafter, the composition 1 was applied by using a spin coating method to obtain an active layer (film-thickness: about 100 nm). Thereafter, a PEDOT : PSS solution (trade name: CLEVIOS AI4083, manufactured by H.C. Starck GmbH) was applied by a spin coating method to obtain a functional layer (film thickness: about 50 nm). Finally, Al was vapor-deposited thereon with a thickness of 100 nm as an anode, by using a vacuum vapor depositing machine. Upon the vapor deposition, the degree of vacuum was 1 to 9 × 10⁻³Pa in all cases. The shape of the resulting organic thin-film solar battery had a square shape of 2 mm × 2 mm.

The photoelectric conversion efficiency of the resulting organic thin-film solar battery was measured by using a solar simulator (trade name: OTENTO-SUNII, made by Bunkoukeiki Co.,Ltd.: AM1.5G filter, irradiance 100 mW/cm²) in which the battery was irradiated with constant light and a voltage thus generated was measured. The photoelectric conversion efficiency was 0.0%.

### -Evaluation-

As can be seen from the above, in the case of using Al as an anode, in the structure where a functional layer that was adjacent to the anode was formed by using a PEDOT : PSS solution having a pH value of 2, no power generation was obtained, while in the structure where a functional layer that was adjacent to the anode was formed by using an HIL691 solution having a pH value of 7, power generation was obtained with a high photoelectric conversion efficiency.

### INDUSTRIAL APPLICABILITY

Since the organic photoelectric conversion element of the present invention exhibits a high photoelectric conversion efficiency, the present invention is industrially extremely useful.

## Claims

1. An organic photoelectric conversion element comprising:
an anode, a cathode, an active layer and a functional layer, wherein
the anode contains a metal,
the anode and the functional layer are adjacent to each other, and
the functional layer is formed by using a solution having a pH value of 5 to 9.

2. The organic photoelectric conversion element according to claim 1, wherein the metal is aluminum, magnesium, titanium, chromium, iron, nickel, copper, zinc, gallium, zirconium, molybdenum, silver, indium or tin.

3. The organic photoelectric conversion element according to claim 1 or 2, wherein the active layer contains a conjugated polymer compound and a fullerene derivative.

4. The organic photoelectric conversion element according to any one of claims 1 to 3, wherein the solution contains a polymer compound and a solvent.
